Europäisches Patentamt

European Patent Office

Office européen des brevets

(11) Publication number: **0 111 803**
**B1**

# (12) EUROPEAN PATENT SPECIFICATION

(45) Date of publication of patent specification: **01.03.89**

(51) Int. Cl.⁴: **H 01 L 29/743**

(21) Application number: **83112186.8**

(22) Date of filing: **03.12.83**

(60) Divisional application **88101734 filed on 02.02.88.**

(54) Lateral insulated-gate rectifier structures.

(30) Priority: **13.12.82 US 449321**

(43) Date of publication of application:
**27.06.84 Bulletin 84/26**

(45) Publication of the grant of the patent:
**01.03.89 Bulletin 89/09**

(84) Designated Contracting States:
**DE FR NL**

(56) References cited:
**EP-A-0 028 797**
**DE-A-2 205 307**
**GB-A-2 088 631**

**IEEE Transactions on Electronic Devices, Vol.**
**ED-27, no. 2, February 1980, pp. 380-386**

(73) Proprietor: **GENERAL ELECTRIC COMPANY**
**1 River Road**
**Schenectady New York 12305 (US)**

(72) Inventor: **Baliga, Bantval Jayant**
**3 Clove Court**
**Clifton Park New York 12065 (US)**

(74) Representative: **Schüler, Horst, Dr. et al**
**Kaiserstrasse 69**
**D-6000 Frankfurt/Main 1 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

### Background of the invention

The present invention relates generally to insulated-gate rectifiers and, more particularly, to insulated-gate rectifiers of lateral configuration according to the first part of claim 1.

Various forms of insulated-gate rectifiers are disclosed in commonly-assigned DE—A—31 47 075.0 by B. J. Baliga and entitled "GATE ENHANCED RECTIFIER". (It may be noted that a "Gate Enhanced Rectifier "GERECT", is alternatively referred to herein as an "Insulated-Gate Rectifier", or "IGR". The two terms are intended to means the same device).

As described in detail in the above-identified DE—A—31 47 075.0 an insulated-gate rectifier (IGR) is a semiconductor device having an insulated gate for controlling current flow between its main terminals, i.e., between its anode and cathode terminals. The gate and conduction channel of an IGR are similar to corresponding elements in a MOSFET (or more generally, an IGFET) with, however, important differences between the two devices (an IGR and a MOSFET) as described in detail in the above-identified DE—A—31 47 075.0.

Structurally, previously-disclosed IGR's are similar to vertical-channel MOSFET's, with an important distinction. In particular, assuming the case of an N-channel device, a $P^+$ (or highly-doped, low-resistivity P-conductivity type) anode region, not found in a MOSFET, is included. A four-layer, i.e. PNPN, device therefore results. Operation also differs from that of a MOSFET a significant result of which being that the IGR has higher forward conductivity.

Considering the two devices in greater detail, in a conventional N-channel power MOSFET, there is an N (or high resistivity N-conductivity type) drift region forming an extension of the MOSFET drain terminal region. Conduction in such a MOSFET occurs primarily by simple electron current flow through a depletion channel induced in a shield base region by an electric field from an insulated gate electrode, without the presence of excess carriers. Due to the lack of excess carriers, the MOSFET has a relatively fast switching speed.

In contrast, in an IGR, the $P^+$ anode region injects minority carriers (e.g. holes) into the N conductivity type region corresponding to the drift region of a MOSFET. This drift region of an SCR constitutes what, for convenience, is herein termed an "active-base" region, signifying that conduction in this particular region involves more than the mere flow of majority carriers, e.g. electrons. Rather, during operation, the holes introduced into the region herein termed the active-base region recombine with electrons introduced from the cathode, increasing device conductivity. The conduction mode is therefore bipolar in part.

As also described in the above-identified DE—A—31 47 075.0 the IGR differs from a four-layer PNPN thyristor, even though some forms of IGR are structurally superficially somewhat similar to MOS-gated SCR or thyristor structures, and even though an IGR may be considered as including a parasitic SCR. Significantly, in the normal operation of an IGR, the gate electrode maintains both turn-on and turn-off control of current flow through the device, and the parasitic SCR is not permitted to latch into a conducting state.

As further described in the above-identifed DE—A—31 47 075.0 to increase turn-off speed, shorts between the device anode and the adjacent N conductivity type active base region may be employed. (For convenience, these shorts are herein termed "anode shorts"). Anode shorts aid in improving turn-off speed of an IGR due to the bipolar conduction mode of an IGR. In particular, during conduction in an IGR, there are excess electrons and holes in the active-base region and, upon turn-off, these excess electrons and holes are momentarily trapped in the active-base region, prolonging device conduction and therefore degrading turn-off speed. Excess holes in the N conductivity type active base region of an IGR exit towards the cathode electrode through the P conductivity type shield base region. However, in the absence of an anode short, there is no similar path for excess electrons in the active base region. The inclusion of anode shorts overcomes this particular shortcoming, with the result that the device turn-off speed is enhanced.

Previous IGR devices as disclosed in the above-identified Baliga Application DE—A—31 47 075.0 comprise vertical-channel structures. For high power switching applications, the vertical-channel structure is optimum. However, the device anode is located at the bottom of the semiconductor wafer. This does not allow isolation of the anode when several IGR devices are integrated on the same chip unless the circuit is restricted to a case where the anodes of all devices are connected together.

### Summary of the invention

Accordingly, it is an object of the invention to provide lateral IGR structures, including means for enhancing the injection of majority carriers from the device anode region into the active base region for increasing device conductivity.

Briefly stated, and in accordance with the invention as claimed, an insulated-gate rectifier of lateral configuration includes a buried layer in the lateral IGR structure for the purpose of enhancing forward current conduction. In particular, a heavily-doped buried layer of opposite conductivity type, i.e., a $P^+$ layer, is formed in the body generally below the active base region layer, more specifically, between the active base region layer and a lightly-doped substrate layer. The $P^+$ buried layer underlies both the first main terminal region, i.e., the $P^+$ anode region, and the active base primary region. During forward conduction operation, the buried layer serves to collect majority carriers, i.e. holes, injected from the anode at the buried layer end below the anode region, and to reinject these holes below the active base primary region.

The $P^+$ buried layer of the invention for enhancing conductivity may be employed in lateral device structures with or without an anode short.

## Brief description of the drawings

While the novel features of the invention are set forth with particularity in the appended claims, the invention, both as to organization and content, will be better understood and appreciated from the following detailed description taken in conjunction with the drawings, in which:

Fig. 1 is a cross-sectional view of a lateral IGR structure including a $P^+$ conductivity type buried layer for enhancing device conduction;

Fig. 2 is a cross-sectional view of a lateral IGR including a $P^+$ buried layer and an anode short.

## Description of the preferred embodiments

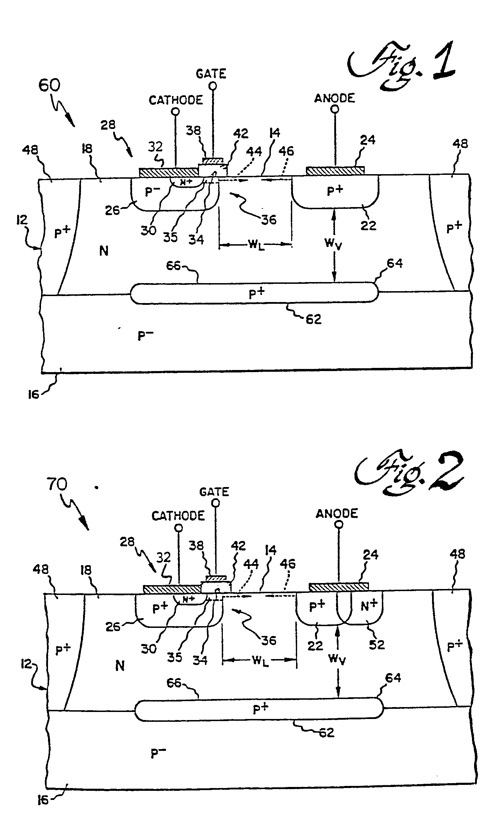

Referring first to Fig. 1, depicted in schematic fashion is an IGR 60 of lateral configuration. Fig. 1 may also be considered as depicting a single unit cell of an overall IGR comprising a plurality of unit cells. The IGR 60 comprises a body of semiconductor material, such as silicon, generally designated 12, and having a principal surface 14. The principal surface 14 is in general the surface at which device connections are made. The body 12 includes a $P^-$ semiconductor substrate 16, i.e. a lightly-doped region of P conductivity type. An active base region layer 18 of N conductivity type is formed over the substrate 16, preferably by means of conventional epitaxial growth techniques, and extends to the principal surface 14. The substrate layer 16 is thus contiguous at an interface 20 with the portion of the active base region layer 18 opposite the principal surface 14.

An island-like anode $P^+$ terminal region 22, i.e., a highly-doped region of P conductivity type, is formed in the body 12 within the active base region 18 and extends to the principal surface 14. A device anode terminal electrode 24 contacts the anode region 22, in preferably ohmic contact therewith. The region 22 may be formed employing conventional photolithographic masking and gas-source diffusion techniques.

The anode region 22 is spaced from the substrate 16 by a vertical width of distance $W_V$, determined primarily by the thickness of the epitaxial layer comprising the active base region 18. To prevent punch-through breakdown of the device 60 during operation, it will be appreciated that the dimension $W_V$ must be greater than the depletion layer width at breakdown.

Also formed in the body 12 within the active base region 18 is an island-like shield base region 26 of $P^-$ conductivity type extending to the principal surface 14 and laterally spaced from the anode region 22 by a drift region lateral width of distance $W_L$. This likewise can be a diffused region. The dimension $W_L$, like $W_V$, must be greater than the depletion layer width at breakdown to prevent punch-through breakdown.

Confined laterally within the shield base region 26 is a device cathode structure, generally designated 28. More particularly, the device cathode structure 28 includes an island-like $N^+$ cathode terminal region 30, i.e. a highly-doped region of N conductivity type, formed in the body 12 within the shield base region 26. It will be appreciated that the shield base 26 and cathode 30 regions may be formed by conventional double-diffusion techniques. A cathode electrode 32 contacts both the cathode region 30 and the shield base region 26, providing a conventional cathode short therebetween. In the IGR 60, this cathode short serves to inhibit operation of the source 30, shield base 26 and active base 18 regions as an NPN bipolar transistor, thus preventing operation of the parasitic PNPN thyristor structure formed by regions 22, 18, 26 and 30 and inherent in the particular IGR 10 structure depicted. A more detailed discussion of a parasitic PNPN structure in the context of a vertical-channel IGR will be found in the above-identified DE—A—31 47 075.0.

A portion of the principal surface 14 serves as a channel surface 34. The shield base region 26 then extends to the channel surface 34 in the DMOS device structure depicted.

The second main terminal structure 28 comprising the cathode region 30 and the cathode electrode 32 is spaced from the active base region 18 to define a channel portion 35 within the shield base region 26 just beneath the channel surface 34. The channel portion 35 extends, within the region 26, from the cathode terminal structure 28 to the active base region 18. More specifically, the channel portion extends to a primary region, generally designated 36, of the active base region 18. The primary active base region 36, as the term is employed herein, is that general region of the active base region 18 into which electrons from the cathode region 30 are channeled during device conduction and, as will be appreciated, does not have definite boundaries.

Typical doping concentrations (that is, the number of dopant atoms per cubic centimeter) for the various regions of the IGR 60 are in the order of the following numbers:

The anode region 22: $1 \times 10^{19}$;

The active base region 18: $1 \times 10^{14}$ to $5 \times 10^{15}$;

The shield base region 26: $1 \times 10^{16}$ to $5 \times 10^{18}$; and

The cathode region 30: $> \times 10^{19}$.

While the form of device 60 illustrated in Fig. 1 includes an $N^+$ cathode region 30, such is not strictly necessary in an IGR, as, in an enhancement mode device, a sufficient N conductivity type accumulation region can in some cases be formed in the P conductivity type shield base region 26 by inversion under the influence of an electric field from the gate electrode, which is described next.

In particular, the device 60 additionally includes an insulated gate electrode 38 over the channel portion 35 configured for inducing in the shield base region 26, at the surface 34, when gate voltage is applied thereto, an inversion channel region for controlling conduction in the channel portion 35 to conductively couple the second main terminal structure 28 and the active base region 18. As is known, the voltage applied to the gate electrode 38 region can either cause a normally-conducting channel to cease conducting, or cause a normally non-conducting channel to conduct. In the illustrated embodiment, the latter is the case, and an induced N conductivity type inversion channel extends between the cathode terminal structure 28 and the active base region 18 or, more particularly, between the cathode region 30 and the primary region 36 of the active base region 18. The gate electrode 38 is insulated from the semiconductor body 12 by an underlying insulating layer 42 which may comprise, for example, silicon dioxide or silicon nitride. The gate electrode 38 itself may, for example, comprise aluminum or highly-doped polycrystalline silicon of either conductivity type, as is known in the art.

To complete the device structure, a P$^+$ isolation region 48 surrounds the active device regions, in accordance with a known technique for electrically isolating devices which are formed on a common P$^-$ substrate.

As will be appreciated by those skilled in the art, a number of additional details are needed to complete the device structure. For example, a passivating oxide or other insulating layer (not shown) is required over the entire exposed surface of the semiconductor body 12, rather than just in the gate insulating area 42. Similarly, a wide variety of surface geometry and interdigitation patterns may be employed. Also, as noted above, the IGR 60 may be viewed as a single unit cell of an overall device structure. Further, various techniques may be employed to contact the cathode electrode 32 and the gate electrode 38. Fig. 1 implies individual patterned metal electrode areas on the surface of the device 60. However, completely encased gate electrode 38 structures may be employed, with remote gate contacts (not shown), in combination with cathode metallization covering the entire visible surface of the device 60.

In operation, upon biasing the gate electrode 38 with a positive voltage with respect to cathode 32 above a threshold value and below a positive voltage applied to the anode 24 with respect to the cathode 32, a portion of the P conductivity type shield base region 26 at the surface 14 just below the gate insulator 42 becomes "inverted", i.e., more populated by minority carriers (electrons) than majority carriers (holes). The channel portion 35 then conducts electrons from the cathode terminal structure 28 to the primary region 36 of the active base region 18. Electron current is represented by dashed line 44.

At the same time, the P$^+$ conductivity type anode region 22 injects majority carriers (holes) into the active base region 18, some of which follow an exemplary hole current path represented by dashed line 46. Electrons in the electron current path 44 recombine in the active base region 18 with holes in the hole current path 42, thus determining the current through the IGR 60. Thus, the device 60 is a bipolar mode conduction device.

The device structure 60 in accordance with the invention is suited for enhanced forward current conduction. Specifically, the device 60 of Fig. 1 includes a P$^+$ buried layer formed in the body 12 between portions of the active base region layer 18 and the substrate layer 16. The buried layer 62 generally underlies the anode terminal region 22 and the active base primary region 36. A typical doping concentration for the buried layer 62 is $10^{18}$ dopant atoms per cubic centimeter.

In operation, the P$^+$ buried layer 62 serves to collect majority carriers (holes) injected from the anode region 22 at the P$^+$ buried layer end 64 below the P$^+$ anode diffusion 22, and to reinject these holes at the buried layer end 66 generally underlying the primary region 36 of the active base region 18.

The buried layer 62 can be formed employing conventional techniques. For example, a typical fabrication process begins with the substrate layer 16, and suitable impurities, i.e., dopant atoms, are introduced through a suitable mask to define the location of the buried layer 62. Thereafter, the mask is removed and the active base region layer 18 epitaxially grown over the substrate 16. As depicted, the buried layer 62 extends slightly up into the active base region 18 due to autodoping during vapor phase or liquid phase epitaxial growth. In particular, during the initial stages of epitaxial growth to form the active base region 18, some of the P$^+$ type dopant enters the gas or liquid phase and is then deposited as part of the epitaxial layer.

Fig. 2 illustrates an insulated gate rectifier structure 70 embodying the invention and including both a P$^+$ buried layer 62 as depicted in Fig. 1, and an anode shorting region 52. In particular, the island-like N$^+$ anode terminal short region 52 is formed in the body 12 within the active base region 18 and extending to the principal surface 14. The anode terminal electrode 24 contacts the anode shorting region 52, in addition to contacting the anode region 22 itself.

This particular anode short structure is easily fabricated by overlapping the N$^+$ and P$^+$ diffusions during processing by means of separate photolithographic masks.

The anode short has the effect of enhancing the turn-off speed of the IGR 70 by enabling majority carriers in the N conductivity type active base region 18 (i.e., electrons) to be rapidly drawn out of the active base region 18 and to the anode electrode 24 which, in circuit operation, would have a positive bias with respect to the cathode electrode 32. In other words, a path for rapid removal of electrons is provided such that excess majority carriers (electrons) are rapidly removed.

In view of the foregoing, it will be appreciated that the present invention provides an improved lateral IGR device structure with enhanced conductivity.

While specific embodiments of the invention have been illustrated and described herein, it is realized that numerous modifications and changes will occur to those skilled in the art. For example, the invention applies to complementary devices, wherein P-type regions are used in place of the N-type regions described herein, and vice-versa. Further it will be appreciated that the devices of Figs. 1 and 2 may also be modified to comprise a VMOS structure.

**Claims**

1. An insulated-gate rectifier of lateral configuration comprising:
a body (12) of semiconductor material having a principal surface (14) and including an active base region layer (18) of one conductivity type extending to said principal surface (14),
first main terminal structure including a heavily-doped island-like first main terminal region (22) of opposite conductivity type formed in said body within said active base region (18) and extending to said principal surface (14), and including a first terminal electrode (24) contacting said first main terminal region (22);
a shield base region (26) of opposite conductivity type formed in said body within said active base region (18) laterally spaced from said first main terminal region (22);
second main terminal structure (28) spaced from said active base region (18) to define a channel portion (35) in said shield base region (26) extending between said second main terminal structure (28) and a primary region of said active base region (18), said second main terminal structure (28) including a second main terminal electrode (32);
an insulated gate electrode (38) over said channel portion (35) and configured for inducing in said channel portion (35), when gate voltage is applied thereto, an inversion channel region conductively coupling said second main terminal structure (28) and said active base region (18); characterized by
a heavily doped buried layer (62) of opposite conductivity type formed in said body (12) between portions of said active base region layer (18) and a lightly-doped substrate layer (16) of a conductivity type opposite to said active base region (18) and contiguous with said active base region layer (18) opposite said principal surface, said buried layer (62) generally underlying both said first main terminal region (22) and said active base primary region so as to collect majority carriers injected during forward conduction from said first main terminal and to reinject the majority carriers into said active base primary region for enhancing forward current conduction;
said active base region (18), said shield base region (26), said buried layer (62) and said terminal structures being configured and arranged such that said insulated-gate rectifier supports conduction in a forward direction between said main terminal electrodes (24, 32) when said inversion channel region exists and such that said insulated-gate rectifier ceases to support conduction in a forward direction when said inversion channel region ceases to exist.

2. An insulated-gate rectifier in accordance with claim 1, wherein said second main terminal structure (28) further includes a heavily-doped island-like second main terminal region (30) of the one conductivity type formed in said body within said shield base region (26), and wherein said second terminal electrode (32) contacts said second main terminal region (30).

3. An insulated-gate rectifier in accordance with claim 2, wherein said second terminal electrode (32) additionally contacts said shield base region (26) to provide a short between said second main terminal region and said base region.

4. An insulated-gate rectifier in accordance with claim 1 or 2, which further comprises an island-like first terminal shorting region (52) of the one conductivity type formed in said body within said active base region (18) and extending to said principal surface (14), and wherein said first terminal electrode (24) additionally contacts said first terminal shorting region (52) to provide a short between said first main terminal region (22) and said active base region (18).

5. An insulated-gate rectifier in accordance with any one of claims 1 to 4, wherein
said active base region (18) is of N conductivity type;
said shield base region (26) is of P conductivity type;
said first main terminal region (22) is of N conductivity type and constitutes an anode region of said rectifier;
said second main terminal region (30) is of N conductivity type and constitutes a cathode region of said recitifier; and
said insulated gate electrode (38) is configured for inducing in said channel portion (35) an inversion channel region of N conductivity type when said gate electrode (38) is biased positively with respect to the cathode region.

**Patentansprüche**

1. Lateraler Gleichrichter mit isoliertem Gate, enthaltend:
einen Körper (12) aus Halbleitermaterial, der eine Hauptfläche (14) und eine aktive Basisbereichschicht (18) des einen Leitfähigkeitstyps aufweist, die sich über die Hauptfläche (14) erstreckt,
eine erste Hauptanschlußstruktur, die einen stark dotierten, inselartigen ersten Hauptanschlußbereich (22) des entgegengesetzten Leitfähigkeitstyps, der in dem Körper innerhalb des aktiven Basisbereiches (18) ausgebildet ist und sich zur Hauptfläche (14) erstreckt, und eine erste Hauptelektrode (24) aufweist, die mit dem ersten Hauptanschlußbereich (22) in Kontakt ist,
einen Abschirmungsbasisbereich (26) des entgegengesetzten Leitfähigkeitstyps, der in dem Körper innerhalb des aktiven Basisbereiches (18) mit seitlichem Abstand zu dem ersten Hauptanschlußbereich (22) ausgebildet ist,

eine zweite Hauptanschlußstruktur (28), die im Abstand von dem aktiven Basisbereich (18) angeordnet ist, um einen Kanalabschnitt (35) in dem Abschirmungsbasisbereich (26) zu bilden, der sich zwischen der zweiten Hauptanschlußstruktur (28) und einem primären Bereich des aktiven Basisbereiches (18) erstreckt, wobei die zweite Hauptanschlußstruktur (28) eine zweite Hauptanschlußelektrode (32) aufweist,

eine isolierte Gate-Elektrode (38), die über dem Kanalabschnitt (35) angeordnet und so konfiguriert ist, daß in dem Kanalabschnitt (35), wenn daran eine Gate-Spannung angelegt ist, ein Inversionskanalbereich induziert wird, der die zweite Hauptanschlußstruktur (28) und den aktiven Basisbereich (18) leitend koppelt, gekennzeichnet durch:

eine stark dotierte vergrabene Schicht (62) des entgegengesetzten Leitfähigkeitstyps, die in dem Körper (12) zwischen Abschnitten der aktiven Basisbereichschicht (18) und einer leicht dotierten Substratschicht (16) eines Leitfähigkeitstyps entgegengesetzt zu dem aktiven Basisbereich (18) ausgebildet ist und mit der aktiven Basisbereichschicht (18) gegenüber der Hauptoberfläche zusammenhängt, wobei die vergrabene Schicht (62) im allgemeinen unter sowohl dem ersten Hauptanschlußbereich (22) als auch dem primären Bereich des aktiven Basisbereiches liegt, um Majoritätsträger zu sammeln, die während der Vorwärtsleitung aus dem ersten Hauptanschluß injiziert sind, und um die Majoritätsträger in den primären Bereich des aktiven Basisbereiches zurück zu injizieren zum Verstärken der Vorwärtsstromleitung,

wobei der aktive basisbereich (18), der Abschirmungsbasisbereich (26), die vergrabene Schicht (62) und die Anschlußstrukturen so konfiguriert und angeordnet sind, daß der Gleichrichter mit isoliertem Gate die Leitung in Vorwärtsrichtung zwischen den Hauptanschlußelektroden (24, 32) unterstützt, wenn der Inversionskanalbereich existiert, und daß der Gleichrichter mit isoliertem Gate die Leitung in einer Vorwärtsrichtung nicht mehr unterstützt, wenn der Inversionskanalbereich nicht mehr existiert.

2. Gleichrichter mit isoliertem Gate nach Anspruch 1, wobei die zweite Hauptanschlußstruktur (28) weiterhin einen stark dotierten, inselähnlichen zweiten Hauptanschlußbereich (30) des einen Leitfähigkeitstyps aufweist, der in dem Körper innerhalb des Abschirmungsbasisbereiches (26) ausgebildet ist, und wobei die zweite Anschlußelektrode (32) mit dem zweiten Hauptanschlußbereich (30) in Kontakt ist.

3. Gleichreichtet mit isoliertem Gate nach Anspruch 2, wobei die zweite Anschlußelektrode (32) zusätzlich mit dem Abschirmungsbasisbereich (26) in Kontakt ist, um einen Kurzschluß zwischen dem zweiten Hauptanschlußbereich und dem Basisbereich zu bilden.

4. Gleichrichter mit isoliertem Gate nach Anspruch 1 oder 2, der ferner einen inselähnlichen ersten Anschlußkurzschlußbereich (52) des einen Leitfähigkeitstyps aufweist, der in dem Körper innerhalb des aktiven Basisbereiches (18) ausgebildet ist, und sich zur Hauptfläche (14) erstreckt, und wobei die erste Anschlußelektrode (24) zusätzlich mit dem ersten Anschlußkurzschlußbereich (52) in Kontakt ist, um einen Kurzschluß zwischen dem ersten Hauptanschlußbereich (22) und dem aktiven Basisbereich (18) zu bilden.

5. Gleichrichter mit isoliertem Gate nach einem der Ansprüche 1 bis 4, wobei

der aktive Basisbereich (18) N-leitend ist,

der Abschirmungsbasisbereich (26) P-leitend ist,

der erste Hauptanschlußbereich (22) N-leitend ist und einen Anodenbereich des Gleichrichters bildet,

der zweite Hauptanschlußbereich (30) N-leitend ist und einen Kathodenbereich des Gleichrichters bildet und

die isolierte Gate-Elektrode (38) so konfiguriert ist, daß sie in dem Kanalabschnitt (35) einen N-leitenden Inversionskanalbereich induziert, wenn die Gate-Elektrode (38) in bezug auf den Kathodenbereich positiv vorgespannt ist.

**Revendications**

1. Redresseur à porte isolée à configuration latérale comprenant:

—un corps (12) de matériau semi-conducteur ayant une surface principale (14) et comportant une couche de région de base active (18) d'un type de conductivité s'étendant jusqu'à la surface principale (14);

—une première structure terminale principale comprenant une première région terminale principale (22) en forme d'île, fortement dopée, d'un type de conductivité opposée, formée dans le corps à l'intérieur de la région de base active (18) et s'étendant jusqu'à la surface principale (14), et comportant une première électrode terminale (24) en contact avec la première région terminale principale (22);

—une région de base formant écran (26) du type de conductivité opposée, formée dans le corps à l'intérieur de la région de base active (18) latéralement espacée de la première région terminale principale (22);

—une seconde structure terminale principale (28) espacée de la région de base active (18) pour définir une partie à canal (35) dans la région de base formant écran (26), s'étendant entre la seconde structure terminale principale (28) et une région principale de la région de base active (18), cette seconde structure terminale principale (28) comportant une seconde électrode terminale principale (32);

—une électrode de porte isolée (38) sur la partie à canal (35) et configurée de manière à induire dans la partie à canal (35), lorsqu'une tension de porte lui est appluquée, une région à canal d'inversion couplant par conductivité la seconde structure terminale principale (28) et la région de base active (18), caractérisé par:

—une couche ensevelie fortement dopée (62) du type de conductivité opposé formée dans le corps (12) entre des portions de la couche de la région de base active (18) et une couche de substrate légèrement dopée (16) d'un type de conductivité opposé à la région de base active (18) et contigüe à la couche de la région de base active (18) opposée à la surface principale, la couche ensevelie (62) étant généralement au dessous de la première région terminale principale (22) et de la région principale de base active de façon à recuellir les porteurs majoritaires injectés pendant la conduction directe à partir de la première région terminale principale et à réinjecter les porteurs majoritaires dans la région principale de base active afin d'améliorer la conduction du courant direct;

la région de base active (18), la région de base formant écran (26), la couche ensevelie (62) et les structures terminales étant configurées et disposées de façon que le redresseur à porte isolée supporte la conduction dans une direction directe entre les électrodes terminales principales (24, 32) lorsque la région à canal d'inversion existe et de façon que le redresseur à porte isolée cesse de supporter la conduction dans une direction directe lorsque la région à canal d'inversion cesse d'exister.

2. Redresseur à porte isolée selon la revendication 1, dans lequel la seconde structure terminale principale (28) comprend en outre une seconde région terminale principale en forme d'île fortement dopée (30) du premier type de conductivité formée dans le corps à l'intérieur de la région de base formant écran (26), et dans lequel la seconde électrode terminale (32) est en contact avec la seconde région terminale principale (30).

3. Redresseur à porte isolée selon la revendication 2, dans lequel la seconde électrode terminale (32) est de plus en contact avec la région de base formant écran (26) afin de fournir un court-circuit entre la seconde région terminale principale et la région de base.

4. Redresseur à porte isolée selon la revendication 1 ou la revendication 2, qui comprend en outre une première région terminale de court-circuit en forme d'île (52) du premier type de conductivité formée dans le corps à l'intérieur de la région de base active (18) et s'étendant jusqu'à la surface principale (14), et où la première électrode terminale (24) est en outre en contact avec la première région terminale de court-circuit (52) pour fournir un court-circuit entre la première région terminale principale (22) et la région de base active (18).

5. Redresseur à porte isolée selon l'une quelconque des revendications 1 à 4, dans lequel:
—la région de base active (18) est du type de conductivité N;
—la région de base formant écran (26) est du type de conductivité P;
— la première région terminale principale (22) est du type de conductivité N et constitue une région d'anode du redresseur;
—la seconde région terminale principale (30) est du type de conductivité N et constitue une région de cathode du redresseur, et
—l'électrode de porte isolée (38) est configurée pour induire dans la portion à canal (35) une région à canal d'inversion du type de conductivité N lorsque l'électrode de porte (38) est polarisée positivement par rapport à la région de cathode.

*Fig. 1*

*Fig. 2*